# EUROPÄISCHE PATENTSCHRIFT

(11) **EP 3 706 311 B1**
(45) Veröffentlichungstag und Bekanntmachung des Hinweises auf die Patenterteilung: **29.11.2023**
(21) Anmeldenummer: 20156362.4
(22) Anmeldetag: 10.02.2020
(51) Int. Cl.: H02P 29/024

(54) **VERFAHREN ZUR ERKENNUNG EINES FEHLERHAFTEN BETRIEBS EINES ÜBER EINEN GLEICHSTROMMOTOR ANGETRIEBENEN GASGEBLÄSES**
METHOD FOR DETECTING FAULTY OPERATION OF A GAS BLOWER DRIVEN BY A DIRECT CURRENT MOTOR
PROCÉDÉ DE DÉTECTION D'UN MAUVAIS FONCTIONNEMENT D'UN SOUFFLEUR À GAZ ENTRAINÉ PAR UN MOTEUR À COURANT CONTINU

(30) Priorität: 07.03.2019 DE 102019105749
(43) Veröffentlichungstag der Anmeldung: 09.09.2020
(73) Patentinhaber: ebm-papst Landshut GmbH, 84030 Landshut (DE)
(72) Erfinder: Weingart, Markus, 84056 Rottenburg (DE); Simon, Bernhard, 93059 Regensburg (DE)
(74) Vertreter: Staeger & Sperling Partnerschaftsgesellschaft mbB

(56) Entgegenhaltungen:
- DE-A1-102011 090 075
- DE-A1-102014 215 458
- DE-A1-102016 006 472

## Beschreibung

Die Erfindung betrifft ein Verfahren zur Erkennung eines fehlerhaften Betriebs eines über einen elektronisch kommutierten Gleichstrommotor angetriebenen Gasgebläses unter Nutzung der Motorelektronik.

Gasgebläse werden bei Heizthermen verwendet, um die belastungsabhängige Gas-Luft-Gemischmenge an den Brenner der Heiztherme zu fördern. Dabei gibt es eine Vielzahl von Einflussfaktoren, welche einen Betrieb des Gasgemischgebläses außerhalb des Sollbereichs verursachen kann.

Derartige Einflussfaktoren basieren in einer ersten Gruppe auf Fehlern beim Gleichstrommotor, beispielsweise einer falschen Kommutierung, einer über die Lebensdauer abnehmenden Magnetstärke am Rotor, einem Temperaturanstieg der Wicklungen oder des Magneten, wodurch das Magnetfeld sinkt, oder einer Unterspannung. Zum anderen ergeben sich in einer zweiten Gruppe Fehler aufgrund von erhöhter Lagerreibung des Rotors oder bei Störkörpern, welche das Laufrad des Gebläses beeinträchtigen. Als dritte Gruppe von Einflussfaktoren gibt es diejenigen, welche auf einer veränderten Aerodynamik basieren, beispielsweise aufgrund einer sich verändernden Luftdichte oder einem verstopften Ansaugbereich oder Abgasrohr.

Druckschriftlicher Stand der Technik im vorliegenden technischen gebiet ist offenbart in den Dokumenten DE 10 2011 090 075 A1, DE 10 2016 006 472 A1 und DE 10 2014 215 458 A1.

Der Erfindung liegt deshalb die Aufgabe zugrunde, einen fehlerhaften Betrieb eines Gasgebläses aufgrund von motorischen, mechanischen oder aerodynamischen Fehlern über die Motorelektronik des Gleichstrommotors zu identifizieren.

Diese Aufgabe wird durch die Merkmalskombination gemäß Patentanspruch 1 gelöst.

Erfindungsgemäß wird ein Verfahren zur Erkennung eines fehlerhaften Betriebs eines über einen elektronisch kommutierten Gleichstrommotor angetriebenen Gasgebläses vorgeschlagen, bei dem der Gleichstrommotor des Gasgebläses über eine integrale Motorelektronik geregelt wird. Über die Motorelektronik wird eine im Betrieb benötigte elektrische Stromaufnahme des Gleichstrommotors zur Erreichung einer vorbestimmten Gebläsedrehzahl des Gasgebläses als Messgröße gemessen. Dabei erfolgt durch die Motorelektronik eine Plausibilitätskontrolle der gemessenen elektrischen Stromaufnahme, bei welcher der gemessene Wert der elektrischen Stromaufnahme bei der vorbestimmten Gebläsedrehzahl mit einer in der Motorelektronik hinterlegten Referenzwertkennlinie der Stromaufnahme verglichen wird und bei Abweichungen des gemessenen Werts der elektrischen Stromaufnahme außerhalb eines Toleranzkorridors um die Referenzkennlinie von der Motorelektronik eine Warnung und/oder ein Fehlercode ausgegeben wird. Dabei kann eine Warnung auch einen Fehlercode auslösen.

Alternativ zur elektrischen Stromaufnahme kann stets auch jede hierzu proportionale physikalische Größe, beispielsweise die Leistung des Gleichstrommotors verwendet werden. Die vorliegend betroffene elektrische Stromaufnahme ist stets der Strom, der durch den Wickel des Stators fließt.

Jeder der vorstehend beschriebenen Einflussfaktoren bzw. Fehler führt dazu, dass die elektrische Stromaufnahme des Gleichstrommotors bei einer bestimmen Gebläsedrehzahl höher oder niedriger ist als eine Referenzwert, der auf der Referenzwertkennlinie hinterlegt ist. Dabei gibt es die Tendenz, dass die motorbedingten Fehler der ersten Gruppe und die mechanischen Fehler der zweiten Gruppe zu einer Erhöhung der elektrischen Stromaufnahme, die auf Aerodynamik basierenden Fehler der dritten Gruppe zu einer Absenkung der der elektrischen Stromaufnahme führen. Es wird deshalb als ein Teil des erfindungsgemäßen Verfahrens ferner vorgesehen, dass die Abweichung in ein Überschreiten und ein Unterschreiten der Referenzwertkennlinie klassifiziert und aus der Klassifizierung eine Fehlerart bestimmt wird. Beim Überschreiten des Referenzgrenzwerts der Referenzwertkennlinie kann auf einen Fehler der ersten beiden Gruppen, beim Unterschreiten auf einen Fehler der dritten, die Aerodynamik betreffenden Gruppe geschlossen werden.

Das Gasgebläse wird vornehmlich in verschiedenen belastungsabhängigen Zuständen, dort jedoch im Wesentlichen bei jeweils konstanter Drehzahl betrieben. Die Motorelektronik erfasst vorzugsweise kontinuierlich die jeweils tatsächlich vorliegende elektrische Stromaufnahme bei der jeweiligen Drehzahl und vergleicht diese mit dem Referenzwert der Referenzwertkennlinie. Die Warnung und/oder der Fehlercode werden/wird ausgegeben, wenn der gemessene Wert der elektrischen Stromaufnahme bei der vorbestimmten Gebläsedrehzahl einen Referenzwert der Referenzwertkennlinie bei der vorbestimmten Gebläsedrehzahl um eine Maximalabweichung übersteigt oder unterschreitet. Die Maximalabweichung bestimmt dabei den Toleranzkorridor. Die vorstehende Betrachtung berücksichtigt einen quasi-stationären Fall, d.h. wenn sich die Drehzahl für eine bestimmte Zeit nicht ändert. Im instationären Fall darf die Stromaufnahme auch höher sein und außerhalb des Toleranzkorridors liegen, da eine hohe Dynamik des Gasgebläses gewünscht ist, bei der das Laufrad schnell auf höhere Drehzahlen beschleunigen kann.

Das Verfahren ist ferner in einer Ausführungsvariante dadurch gekennzeichnet, dass der Wert der elektrischen Stromaufnahme bei der vorbestimmten Gebläsedrehzahl über die Zeit in regelmäßigen Abständen oder kontinuierlich gemessen wird und die Warnung und/oder der Fehlercode erst dann ausgegeben wird, wenn der Wert der elektrischen Stromaufnahme über einen vorbestimmten Zeitraum außerhalb des Toleranzkorridors um die Referenzwertkennlinie liegt. Insbesondere bei die Aerodynamik betreffenden Fehlerarten spielt der Faktor Zeit eine erhebliche Rolle, da Veränderungen beispielsweise aufgrund Verschmutzung üblicherweise langsam fortschreiten und sich die für eine bestimmte Drehzahl benötige Stromaufnahme des Gleichstrommotors entsprechend nur langsam verringert. Der vorgeschlagene Verfahrensschritt berücksichtigt dies durch Erfassung zeitlicher Gradienten der gemessenen Stromaufnahme, so dass eine Warnung und/oder ein Fehlercode erst dann ausgegeben werden, wenn die Abweichung gegenüber der Referenzwertkennlinie über einen festgelegten Zeitraum detektiert wird.

Die Referenzwertkennlinie wird für jeden der verwendeten Gleichstrommotoren jeweils individuell in der jeweiligen Einbausituation labortechnisch ermittelt und in der Motorelektronik gespeichert. Somit ist ein möglichst exakter Abgleich zu den Sollwerten der elektrischen Stromaufnahme ermöglicht.

In einer Weiterbildung des Verfahrens ist vorgesehen, dass die Motorelektronik eine von der Drehzahl des Gasgebläses abhängige maximale Strombegrenzung aufweist. Bei der Strombegrenzung wird der gemessene Wert der elektrischen Stromaufnahme bei der vorbestimmten Gebläsedrehzahl mit einem zulässigen Maximalwert verglichen und bei einer Überschreitung des Maximalwerts die elektrische Stromaufnahme des Gleichstrommotors auf den Maximalwert begrenzt. Dies stellt sicher, dass beispielsweise bei einer Blockade des Gleichstrommotors zu hohe Ströme vermieden werden und die Drehzahl des Gasgemischgebläses begrenzt wird. Ferner verhindert die Strombegrenzung eine zu starke Erwärmung des Gleichstrommotors.

In einer vorteilhaften Ausführung wird an der Motorelektronik eine Übertragungseinrichtung mit einer Schnittstelle zur Übertragung des gemessenen und auf der Motorelektronik ausgewerteten Werts der elektrischen Stromaufnahme an eine an das Gasgebläse angeschlossene Heiztherme vorgesehen. Die Kommunikation und Übertragung des gemessenen und ausgewerteten Werts an die Heiztherme erfolgt beispielsweise über ein BUS-System. Dabei ist vorteilhaft, dass elektronisch erfasste und durch eine Plausibilitätskontrolle geprüfte bzw. ausgewertete Werte der elektrischen Stromaufnahme des Gleichstrommotors an ein externes Gerät (Heiztherme) übermittelt werden können, das selbst über ein Steuergerät geregelt wird. Somit muss das Gerät bzw. die Heiztherme nicht selbst über eine Einrichtung zur Fehlererkennung verfügen, vielmehr kann das Steuergerät der Heiztherme bereits auf die von der Motorelektronik gelieferten Signale bzw. Warnungen und Fehlercodes zurückgreifen. Der Applikationsaufwand am Gerät bzw. der Heiztherme ist somit geringer.

Das Verfahren ist in einer Weiterbildung ferner dadurch gekennzeichnet, dass die Motorelektronik einen auslesbaren Fehlerspeicher umfasst, in dem die Warnungen und/oder Fehlercodes der Plausibilitätskontrolle gespeichert werden. Im Wartungsfall kann hierdurch über ein Auslesegerät festgestellt werden, welche Fehler im laufenden Betrieb erfasst und abgespeichert wurden.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1: ein Diagramm der Druckerhöhung gegenüber dem Volumenstrom des Gasgebläses bei der Fehlerart einer abnehmenden Luftdichte,
- Fig. 2: ein Diagramm der Druckerhöhung gegenüber dem Volumenstrom des Gasgebläses bei der Fehlerart eines verstopften Abgasrohres,
- Fig. 3: ein Diagramm der Druckerhöhung gegenüber dem Volumenstrom des Gasgebläses bei der Fehlerart eines sich reduzierenden Wirkungsgrades des Gleichstrommotors,
- Fig. 4: ein Diagramm mit Kennlinien zur elektrischen Stromaufnahme des Gleichstrommotors bei unterschiedlichen Drehzahlen in den Fehlerfällen der Figuren 1-3 sowie mit der Referenzkennlinie;
- Fig. 5: ein Diagramm mit einer Kennlinie der elektrischen Stromaufnahme des Gleichstrommotors im Fehlerfall gemäß der Figur 3 sowie mit der Referenzwertkennlinie und dem Toleranzkorridor in eine Richtung,
- Fig. 6: ein Diagramm zur schematischen Darstellung eines sich über die Zeit verändernden Werts der Stromaufnahme des Gleichstrommotors gegenüber einem Referenzwert.

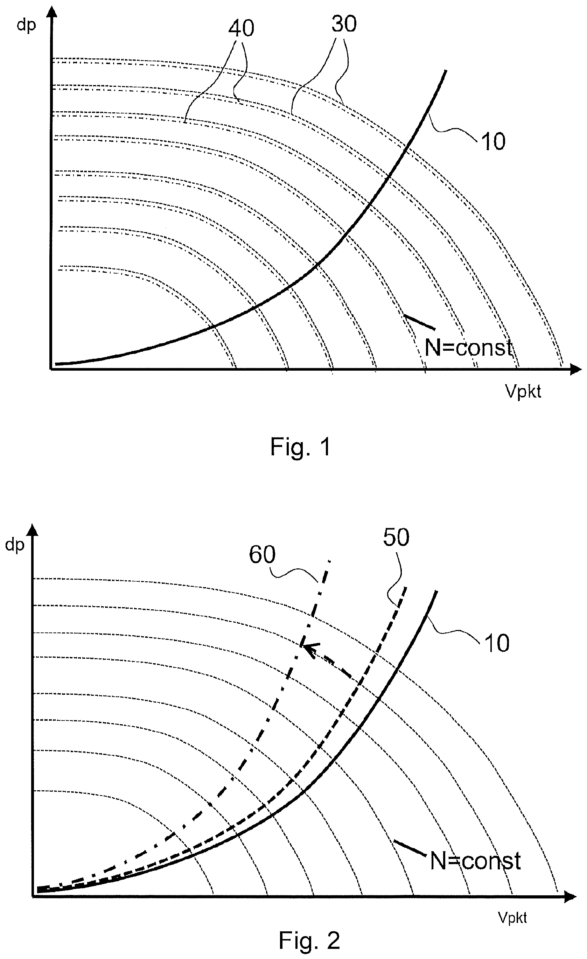

Die Figuren 1-3 zeigen jeweils ein Diagramm der Gebläsekennlinie und Anlagenkennlinie eines Gasgebläses ausgebildet als Radialgebläse bei verschiedenen Fehlerarten als Einflussgrößen, wobei jeweils die Druckerhöhung dp als Ordinate und der geförderte Volumenstrom Vpkt als Abszisse aufgetragen sind.

In Figur 1 ist beispielhaft schematisch der Fehlerfall einer Änderung der Luftdichte dargestellt. Die Anlagenkennlinie 10 (auch "Systemkennlinie" genannt) wird vereinfacht als konstant angenommen. Zudem sind die Referenzkennlinie 30 und die Kennlinie geringerer Luftdichte 40 jeweils bei konstanter Drehzahl N als Bezugsgrößen dargestellt.

Figur 2 zeigt einen ansteigenden Druckverlust aufgrund einen anlagenbedingten Fehlerfalls, beispielsweise eines verstopften Abgasrohres oder eines verschmutzten Wärmetauschers an der Heiztherme, durch den sich die nominelle Anlagenkennlinie 10 bereits bei Inbetriebnahme des Gasgebläses mit der Heiztherme nach links zu einem geringeren Volumenstrom verschiebt (Kennlinie 50) und sich im Betrieb weiter von der nominellen Anlagenkennlinie 10 entfernt (Kennlinie 60).

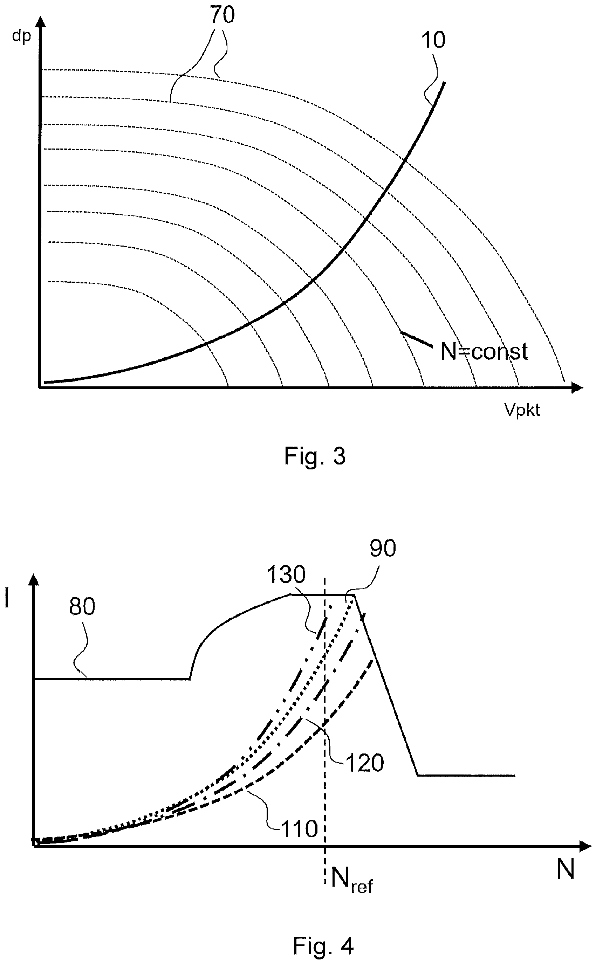

In Figur 3 sind sowohl die Anlage aus auch die Umgebung unbeeinflusst, jedoch ist als Fehlerart beispielhaft die Abnahme des Wirkungsgrades des Motors des Gasgebläses, beispielsweise durch Erwärmung dargestellt. Die Anlagenkennline 10 bleibt hierbei konstant. Ebenso bleiben die Referenzkennlinien 70 bei konstanter Drehzahl N unverändert.

Die Auswirkungen der in den Figuren 1-3 beispielhaft dargestellten Fehlerarten auf die Stromaufnahme I des Gleichstrommotors des Gasgebläses sind im Diagramm gemäß Figur 4 dargestellt. Die Kurve 80 zeigt eine maximal zulässige Stromaufnahme des Gleichstrommotors über den Verlauf der Drehzahl N im instationären Betrieb, also während der Beschleunigung bzw. Erhöhung der Gebläsedrehzahl des Gasgebläses. Diese Stromgrenze ist auf der Motorelektronik implementiert und dient dazu, zu hohe Ströme beispielsweise bei einer Blockade des Gleichstrommotors zu verhindern und die Drehzahl zu begrenzen. Die stationäre Stromaufnahme im quasi-stationären Betrieb bei konstanter Drehzahl N ist geringer. Die Kennlinie 90 stellt hierfür die Referenzwertkennlinie dar. Die Fehlerarten gemäß Figur 1 bezüglich abfallender Luftdichte sowie Figur 2 eines verstopften Abgasrohres führen zu geringeren Strömen bei gleicher Drehzahl N_ref, wohingegen die Erwärmung des Gleichstrommotors und der einhergehende abfallende Wirkungsgrad zu einer Erhöhung der Stromaufnahme bei gleicher Drehzahl N_ref führt. Die Kennlinie 110 stellt die Fehlerart nach Figur 1, die Kennlinie 120 die Fehlerart nach Figur 2 und die Kennlinie 130 die Fehlerart nach Figur 3 dar.

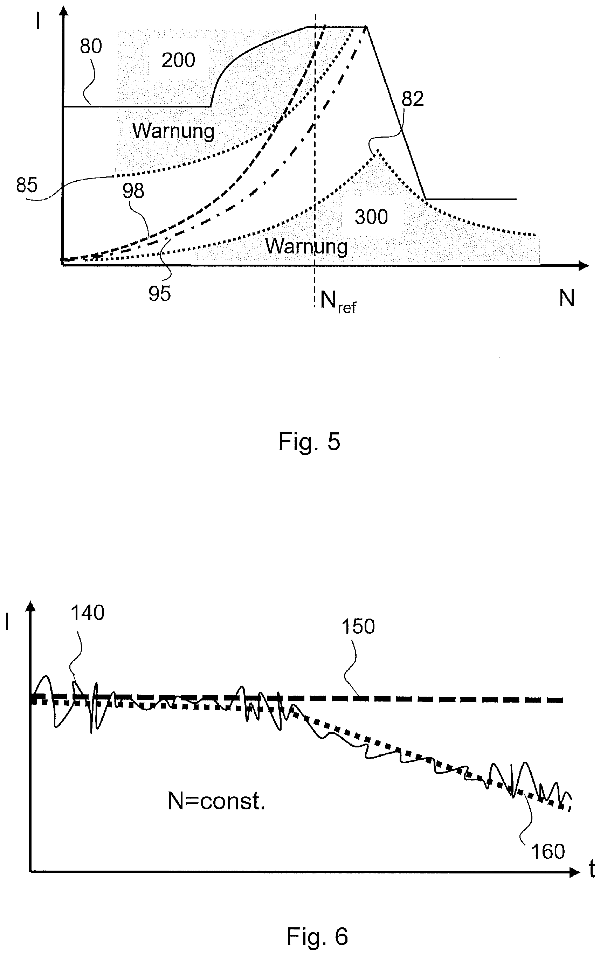

Figur 5 zeigt ein Diagramm mit einer quasi-stationären Kennlinie 98 der elektrischen Stromaufnahme I des Gleichstrommotors beispielhaft im Fehlerfall gemäß der Figur 3 gegenüber der labortechnisch ermittelten Referenzwertkennlinie 95. Um die Referenzwertkennlinie 95 sind jeweils versetzt zwei Kennlinien 82 und 85 vorgegeben, welche den Toleranzkorridor bestimmen. Der Bereich 200 mit höherer Stromaufnahme I bei gleicher Drehzahl N_ref und der Bereich 300 mit vergleichsweise geringerer Stromaufnahme I bei gleicher Drehzahl N_ref liegen außerhalb des Toleranzkorridors. Sobald die Kennlinie 98 die Kennlinie 85 kreuzt und der Betrieb des Gleichstrommotors im Bereich 200 außerhalb des Toleranzkorridors erfolgt, werden die Warnung und der Fehlercode ausgeben. Gezeigt ist nur die Fehlerart gemäß Figur 3, bei einer Fehlerart gemäß Figur 1 oder 2 würde die Kennlinie 98 in den Bereich 300 gelangen. Auch dann wird eine Warnung und/oder ein Fehlercode ausgegeben.

In Figur 6 ist beispielhaft schematisch dargestellt, dass sich der Wert der Stromaufnahme des Gleichstrommotors bei konstanter Drehzahl N gegenüber einem Referenzwert über die Zeit t langsam verändern kann. Die gestrichelte Linie 150 bildet den Referenzwert. Die tatsächlich kontinuierlich gemessene Stromaufnahme 140 schwankt nur gering und kann innerhalb des Toleranzkorridors liegen, sie sinkt jedoch im Zeitverlauf deutlich ab, wie es durch die gemittelte Linie 160 dargestellt ist. Die Warnung und der Fehlercode werden auch dann ausgegeben, wenn der Wert der elektrischen Stromaufnahme zu lange zu weit von der Referenzlinie 150 entfernt liegt.

Die Plausibilitätskontrolle mit dem Vergleich der gemessenen elektrischen Stromaufnahme gegenüber dem Referenzwert der Referenzwertkennlinie erfolgt unmittelbar durch die Motorelektronik des Gasgebläses. Hierzu weist diese unter anderem auch eine Strommesseinrichtung sowie einen elektronischen Steuerbaustein, insbesondere einen Komparator auf.

Bei der Motorelektronik wird der Motorstrom (elektrische Stromaufnahme) parallel zur Überstromüberwachung, welche durch einen Komparator im Mikrocontroller erfolgt, auf einen Analog-Digital-Converter (ADC) des Mikrocontrollers gelegt. Der Motorstrom wird mit einem Shunt gemessen. Das Signal wird dann in der Mitte des PWM-Zyklus (PWM=Pulsweitenmodulation) abgegriffen und umgerechnet. Weiterhin erfolgt bei Bedarf eine Messung der Zwischenkreisspannung und wird mit dem Motorstrom zur Motorleistung verrechnet.

## Patentansprüche

1. Verfahren zur Erkennung eines fehlerhaften Betriebs eines über einen elektronisch kommutierten Gleichstrommotor angetriebenen Gasgebläses, wobei der Gleichstrommotor des Gasgebläses über eine integrale Motorelektronik geregelt wird, wobei über die Motorelektronik eine im Betrieb benötigte elektrische Stromaufnahme oder Motorleistung des Gleichstrommotors zur Erreichung einer vorbestimmten Gebläsedrehzahl des Gasgebläses als Messgröße gemessen wird, wobei eine Plausibilitätskontrolle der gemessenen elektrischen Stromaufnahme durch die Motorelektronik erfolgt, bei welcher der gemessene Wert der elektrischen Stromaufnahme bei der vorbestimmten Gebläsedrehzahl mit einer in der Motorelektronik hinterlegten Referenzwertkennlinie (90, 95) der Stromaufnahme verglichen wird und bei Abweichungen des gemessenen Werts der elektrischen Stromaufnahme außerhalb eines Toleranzkorridors um die Referenzwertkennlinie (90, 95) von der Motorelektronik eine Warnung und/oder ein Fehlercode ausgegeben wird, **dadurch gekennzeichnet, dass** die Abweichung in ein Überschreiten und ein Unterschreiten der Referenzwertkennlinie (90, 95) klassifiziert wird und aus der Klassifizierung eine Fehlerart bestimmt wird.

2. Verfahren nach Anspruch 1, **dadurch gekennzeichnet, dass** die Warnung und/oder ein Fehlercode ausgegeben wird, wenn der gemessene Wert der elektrischen Stromaufnahme bei der Gebläsedrehzahl einen Referenzwert der Referenzwertkennlinie (90, 95) bei der Gebläsedrehzahl um eine vordefinierte Maximalabweichung übersteigt oder unterschreitet.

3. Verfahren nach einem der vorigen Ansprüche, **dadurch gekennzeichnet, dass** der Wert der elektrischen Stromaufnahme bei der Gebläsedrehzahl über die Zeit in regelmäßigen Abständen oder kontinuierlich gemessen wird und die Warnung und/oder der Fehlercode erst dann ausgegeben wird, wenn der Wert der elektrischen Stromaufnahme über einen vorbestimmten Zeitraum außerhalb des Toleranzkorridors um die Referenzwertkennlinie (90, 95) liegt.

4. Verfahren nach einem der vorigen Ansprüche, **dadurch gekennzeichnet, dass** die Referenzwertkennlinie (90, 95) für den jeweiligen Gleichstrommotor labortechnisch ermittelt und in der Motorelektronik gespeichert wird.

5. Verfahren nach einem der vorigen Ansprüche, **dadurch gekennzeichnet, dass** die Motorelektronik eine von der Drehzahl des Gasgebläses abhängige maximale Strombegrenzung aufweist, bei welcher der gemessene Wert der elektrischen Stromaufnahme bei der vorbestimmten Gebläsedrehzahl mit einem zulässigen Maximalwert verglichen wird und bei einer Überschreitung des Maximalwerts die elektrische Stromaufnahme des Gleichstrommotors auf den Maximalwert begrenzt wird.

6. Verfahren nach einem der vorigen Ansprüche, **dadurch gekennzeichnet, dass** an der Motorelektronik eine Übertragungseinrichtung mit einer Schnittstelle zur Übertragung der Warnungen und/oder der Fehlercodes an eine an das Gasgebläse angeschlossene Heiztherme vorgesehen ist, wobei über die Schnittstelle zusätzlich der auf der Motorelektronik gemessene und in der Plausibilitätskontrolle geprüfte Wert der elektrischen Stromaufnahme an eine an das Gasgebläse angeschlossene Heiztherme übertragbar ist.

7. Verfahren nach dem vorigen Anspruch, **dadurch gekennzeichnet, dass** die Warnung und/oder der Fehlercode an die Heiztherme übermittelt wird.

8. Verfahren nach einem der vorigen Ansprüche, **dadurch gekennzeichnet, dass** die Motorelektronik einen auslesbaren Fehlerspeicher umfasst, in dem die Warnungen und/oder Fehlercodes der Plausibilitätskontrolle gespeichert werden.

9. Verfahren nach einem der vorigen Ansprüche, **dadurch gekennzeichnet, dass** die Motorelektronik eine Strommessvorrichtung und einen elektronischen Steuerbaustein, insbesondere einen Komparator oder IC-Steuerbaustein umfasst.

## Claims

1. A method for detecting a faulty operation of a gas blower driven by an electronically commutated DC motor, wherein the DC motor of the gas blower is controlled by an integrated motor electronics, wherein an electrical current draw or motor power of the dc motor required in operation to reach a predetermined blower speed of the gas blower is measured as a measured variable via the motor electronics, wherein a plausibility check of the measured electrical current draw is performed by the motor electronics, in which the measured value of the electrical current draw at the predetermined blower speed is compared to a current draw reference value characteristic (90, 95) stored in the motor electronics, and on deviation of the measured value of the electrical current draw beyond a tolerance range around the reference value characteristic (90, 95) a warning and/or an error code is issued by the motor electronics, **characterized in that** the deviation is classified into either exceeding or falling below the reference value characteristic (90, 95), and that the type of fault is determined from the classification.

2. The method according to claim 1, **characterized in that** the warning and/or an error code is issued if the measured value of the electrical current draw at the blower speed exceeds or falls short of a reference value of the reference value characteristic (90, 95) at the blower speed by a predefined maximum deviation.

3. The method according to one of the preceding claims, **characterized in that** the value of the electrical current draw at the predetermined blower speed is measured over time in regular intervals or continuously, and the warning and/or the error code are/is only issued if the value of the electrical current draw lies outside the tolerance range, around the reference value characteristic (90, 95), over a predetermined period,

4. The method according to one of the preceding claims, **characterized in that** the reference characteristic (90, 95) for the respective DC motor is determined in a laboratory used and is stored in the motor electronics.

5. The method according to one of the preceding claims, **characterized in that** the motor electronics has a maximum current limiting device that is dependent on the speed of the gas blower, in which the measured value of the electric current draw at a predetermined blower speed is compared to an admissible maximum value, and limits the electrical current draw of the DC motor to the maximum value if said maximum value is exceeded.

6. The method according to one of the preceding claims, **characterized in that** a transmission device with an interface for transmitting the warning and/or the error codes to a heating system, which is connected to the gas blower, is provided at the motor electronics, wherein via the interface additionally the value of the electrical current draw, which was measured in the motor electronics and evaluated by the plausibility check, is transmissable to a heating system connected to the gas blower.

7. The method according to the preceding claim, **characterized in that** the warning and/or the error code is transmitted to the heating system.

8. The method according to one of the preceding claims, **characterized in that** the electronic motor control circuit comprises a readable error memory in which the warnings and/or the error codes of the plausibility check are stored.

9. The method according to one of the preceding claims, **characterized in that** the motor electronics comprises a current measuring device and an electronic control module, in particular a comparator or IC control module.

## Revendications

1. Procédé permettant de détecter un mauvais fonctionnement d'une soufflante à gaz entraînée par un moteur à courant continu à commutation électronique, dans lequel le moteur à courant continu de la soufflante à gaz est régulé par une électronique de moteur intégrée, dans lequel une consommation de courant électrique nécessaire en cours de fonctionnement ou une puissance de moteur du moteur à courant continu pour obtenir une vitesse de rotation de soufflante prédéterminée de la soufflante à gaz est mesurée en tant que grandeur de mesure par l'intermédiaire de l'électronique de moteur, dans lequel un contrôle de vraisemblance de la consommation de courant électrique mesurée est effectué par l'électronique de moteur, au cours duquel la valeur mesurée de la consommation de courant électrique à la vitesse de rotation de soufflante prédéterminée est comparée avec une courbe caractéristique de référence (90, 95) de la consommation de courant mémorisée dans l'électronique de moteur, et en cas d'écarts de la valeur mesurée de la consommation de courant électrique en dehors d'une plage de tolérance autour de la courbe caractéristique de référence (90, 95), l'électronique de moteur émet un avertissement et/ou un code d'erreur, **caractérisé en ce que** l'écart est classifié en dépassement et soupassement de la courbe caractéristique de référence (90, 95), et un type d'erreur est déterminé d'après la classification.

2. Procédé selon la revendication 1, **caractérisé en ce que** l'avertissement et/ou un code d'erreur est/sont émis si la valeur mesurée de la consommation de courant électrique dépasse ou soupasse d'un écart maximal prédéfini une valeur de référence de la courbe caractéristique de référence (90, 95) à la vitesse de rotation de soufflante.

3. Procédé selon l'une quelconque des revendications précédentes, **caractérisé en ce que** la valeur de la consommation de courant électrique à la vitesse de rotation de la soufflante est mesurée au cours du temps à intervalles réguliers ou en continu, et l'avertissement et/ou le code d'erreur n'est/ ne sont émis que si la valeur de la consommation de courant électrique se situe en dehors de la plage de tolérance autour de la courbe caractéristique de référence (90, 95) pendant une période de temps prédéterminée.

4. Procédé selon l'une quelconque des revendications précédentes, **caractérisé en ce que** la courbe caractéristique de référence (90, 95) est établie en laboratoire pour le moteur à courant continu respectif et est sauvegardée dans l'électronique de moteur.

5. Procédé selon l'une quelconque des revendications précédentes, **caractérisé en ce que** l'électronique de moteur présente une limitation de courant maximale dépendant de la vitesse de rotation de la soufflante à gaz, à laquelle la valeur mesurée de la consommation de courant électrique à la vitesse de rotation de soufflante prédéterminée est comparée avec une valeur maximale admissible, et en cas de dépassement de la valeur maximale, la consommation de courant électrique du moteur à courant continu est limitée à la valeur maximale.

6. Procédé selon l'une quelconque des revendications précédentes, **caractérisé en ce qu'**au niveau de l'électronique de moteur est prévu un dispositif de transmission équipé d'une interface pour transmettre les avertissements et/ou les codes d'erreur à une chaudière raccordée à la soufflante à gaz, dans lequel par l'intermédiaire de l'interface, il est possible en plus de transmettre à une chaudière raccordée à la soufflante à gaz la valeur de la consommation de courant électrique mesurée au niveau de l'électronique de moteur et vérifiée par le contrôle de vraisemblance.

7. Procédé selon la revendication précédente, **caractérisé en ce que** l'avertissement et/ou le code d'erreur est/sont transmis à la chaudière.

8. Procédé selon l'une quelconque des revendications précédentes, **caractérisé en ce que** l'électronique de moteur comprend une mémoire d'erreurs lisible dans laquelle sont stockés les avertissements et/ou les codes d'erreur du contrôle de vraisemblance.

9. Procédé selon l'une quelconque des revendications précédentes, **caractérisé en ce que** l'électronique de moteur comprend un dispositif de mesure de courant et un composant de commande électronique, en particulier un comparateur ou un composant de commande de Cl.
